# EUROPÄISCHE PATENTSCHRIFT

(11) **EP 0 535 491 B1**
(45) Veröffentlichungstag und Bekanntmachung des Hinweises auf die Patenterteilung: **08.02.1995**
(21) Anmeldenummer: 92116098.2
(22) Anmeldetag: 21.09.1992
(51) Int. Cl.: H05K 3/36, H01R 9/09

(54) **Verfahren zur Herstellung elektrisch leitender Verbindungen an Leiterplatten**
Process for producing electrically conductive connections or printed circuit boards
Procédé de fabrication de connexions électriques conductrices sur des cartes de circuits imprimés

(30) Priorität: 04.10.1991 DE 4132995
(43) Veröffentlichungstag der Anmeldung: 07.04.1993
(73) Patentinhaber: Bodenseewerk Gerätetechnik GmbH, 88662 Überlingen (DE)
(72) Erfinder: Neumann, Werner, W-7776 Owingen (DE)
(74) Vertreter: Weisse, Jürgen, Dipl.-Phys. Patentanwalt

(56) Entgegenhaltungen:
- EP-A- 0 405 828
- DE-A- 2 831 984
- US-A- 4 795 079
- US-A- 4 886 461
- IBM TECHNICAL DISCLOSURE BULLETIN. Bd. 28, Nr. 12, 12. Mai 1986, NEW YORK US, Seite 5621: Termination of flexible printed circuits to rigid printed circuits'

## Beschreibung

### Technisches Gebiet

Die Erfindung betrifft ein Verfahren zum Herstellen elektrisch leitender Verbindungen zwischen Anschlussflächen einer flexiblen Leiterplatte und Anschlussflächen einer starren Leiterplatte, bei dem an den einander zugekehrten Anschlussflächen Lötflächen ausgebildet, die Leiterplatten mit ihren Lötflächen zueinander ausgerichtet und unter Zwischenlage eines wärmehärtenden Klebers durch Anwendung von Wärme und Druck miteinander verbunden werden.

### Zugrundeliegender Stand der Technik

Zur Herstellung einer Verbindung zwischen einer starren und einer flexiblen Leiterplatte unter elektrischer Verbindung von auf den Leiterplatten angeordneten Leiterbahnen ist das sogenannte "Starrflex"-Verfahren bekannt, bei dem ein flexibler Träger für Leiterbahnen, "Flex" genannt, auf einem Teil seiner Länge vollständig in den als starrer Träger dienenden Leiterplattenverbund eingebunden bzw. eingebettet ist. Die Herstellung einer solchen Verbindung kann nur zugleich mit der Herstellung des starren Trägers, der beispielsweise als Sandwichplatte ausgebildet sein kann, erfolgen. Ein solches Verfahren erlaubt es nicht, an dem einmal hergestellten starren Träger wechselnde flexible Träger anzuordnen um etwa wechselnde Schaltungsanordnungen zu ermöglichen.

Weiterhin ist es bekannt, den flexiblen Träger als "Jumper" auszubilden. In diesem Fall erhalten die auf dem flexiblen Träger angeordneten Leiterbahnen stiftförmige oder hakenförmige Verlängerungen. Diese Verlängerungen werden in Hülsen eingeführt die sich in den starren Träger erstrecken und in den Hülsen verlötet. Die hierbei erforderliche Verwendung von sich durch die Stärke des starren Trägers hindurch erstreckenden elektrisch leitenden Bauteilen begrenzt jedoch in empfindlichem Masse die Möglichkeit, auf beiden Seiten der starren Leiterplatte Leiterbahnen und Bestückungen anzuordnen. Es ist auch nicht möglich gegenüberliegend auf beiden Seiten der Leiterplatte Verbindungen anzuordnen und es ist nich möglich, die der Bestückungs- und Verbindungsseite gegenüberliegende Seite der Leiterplatte im Bereich der Verbindungen vollständig mit elektrisch leitendem Material zu kaschieren. Wegen der für die Hülsen erforderlichen Bohrungen ist die Verwendung von keramischem Material für die starre Leiterplatte nicht oder nur unter grössten Schwierigkeiten möglich.

Die JP-A-1-54 797 (Patent Abstracts of Japan E-773, 15,. Juni 1989, Bd. 13/Nr. 259) betrifft einen Träger mit einer vielschichtigen Verbindung. Insbesondere ist darin ein Träger in Form einer starren Leiterplatte beschrieben, die auf einer Seite mit einer Isolierschicht aus Polyimid abgedeckt sist. Die Isolierschicht enthält im Bereich von Leiterbahnen Löcher für die Ausbildung von Lötanschlüssen. Diese Lötanschlüsse werden dadurch gebildet, dass auf die mit der Isolierschicht mit den Löchern bedeckte Seite des Trägers zunächst eine Chromschicht und dann eine Nickel-Kupferlegierung aufgetragen wird. Anschliessend werden diese Schichten in der Weise weggeätzt, dass die Löcher mit aus diesen Schichten gebildeten Lötanschlüssen gefüllt sind, die aus der Oberfläche der Isolierschicht herausragen. Dieses Dokument bezieht sich aussschliesslich auf ein spezielles Verfahren zur Ausbildung von Lötanschlüssen an einer Leiterplatte, nicht aber auf die Herstellung von Lötverbindungen zwischen den Anschlüssen einer flexiblen Leiterplatte und einer starren Leiterplatte.

### Offenbarung der Erfindung

Aufgabe der Erfindung ist ein Verfahren zur Herstellung einer Verbindung zwischen den Leiterbahnen einer starren Leiterplatte und einer als flexible Folie ausgebildeten Leiterplatte. Die Herstellung des starren und des flexiblen Teiles soll getrennt voneinander durchführbar sein, um durch Zusammenfügen verschiedenartig ausgebildeter Teile wechselnde schaltungstechnische und bauliche Anforderungen erfüllen zu können. Die Verbindung soll sich auf einfache Weise herstellen lassen und sowohl in elektrischer als auch mechanischer Hinsicht hohen Anforderungen an die Zuverlässigkeit genügen. Weiterhin soll die Herstellung der Verbindungen ohne Durchkontaktieren der Leiterplatten, insbesondere der starren Leiterplatte, durchführbar sein um deren beiderseitige Bestückung zu erleichtern und die ganzflächige Kaschierung der starren Leiterplatte mit einem elektrisch leitenden Material zu ermöglichen. Schliesslich soll das Verfahren zur Herstellung von Verbindungen auch an keramischen Leiterplatten ohne Schwierigkeiten anwendbar sein.

Erfindungsgemäss werden diese Aufgaben durch ein Verfahren der eingangs genannten Art gelöst bei dem
die starre Leiterplatte im Bereich ausserhalb der Lötflächen mit einer den Lötfluss verhindernden Deckschicht abgedeckt wird und die Lötflächen dadurch in der Oberfläche der starren Leiterplatte versenkt angeordnet werden, und
die flexible Leiterplatte im Bereich ausserhalb der Lötflächen mit einer den Lötfluss verhindernden Deckschicht abgedeckt wird und die Lötflächen aus der Oberfläche der Deckschicht herausragend ausgebildet werden.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.

### Kurze Beschreibung der Zeichnungen

- Fig. 1: ist eine vereinfachte perspektivische Aufsicht auf eine nach dem Verfahren gemäss der Erfindung hergestellte Verbindung.
- Fig. 2: zeigt als Einzelheit aus Fig. 1 Teilabschnitte zweier Leiterplatten vor dem Herstellen der Verbindung.

### Bevorzugte Ausführung der Erfindung

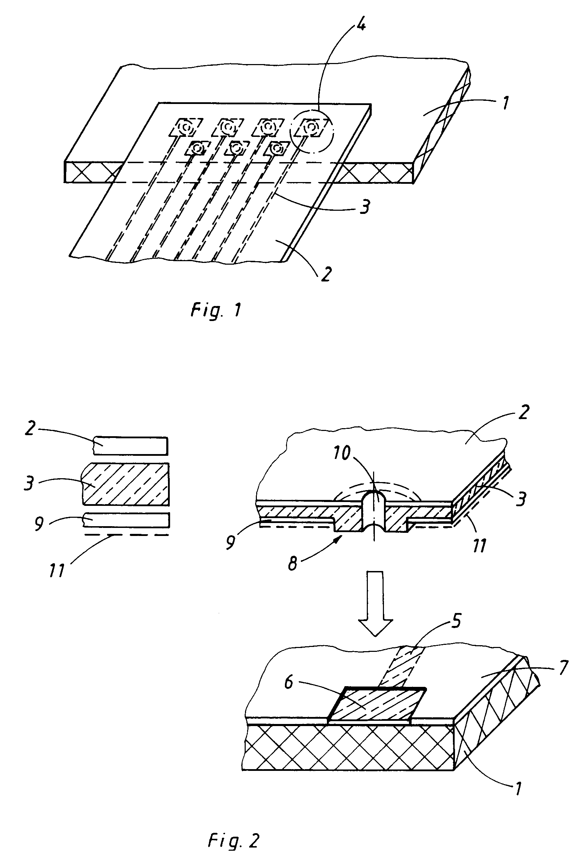

In Fig. 1 ist ein erster Träger, eine starre Leiterplatt, mit 1 bezeichnet. Die starre Leiterplatte kann aus einem der üblicherweise verwendeten Meterialien bestehen, beispielsweise aus glasfaserverstärktem Kunststoff, aber auch aus einem keramischen Material. Die als flexibler Träger dienende Leiterplatte 2, die auch "Flex" genannt wird, kann eine aus einem thermostabilen Polimid bestehende Folie sein (z.B. Kapton der Fa. Du Pont). Die Leiterbahnen 3 befinden sich in der zeichnerischen Darstellung der Fig. 1 innerhalb der flexiblen Leiterplatte 2 und sind im in der Zeichnung dargestellten Endbereich der Leiterplatte 2 von deren Unterseite her zugänglich. Die auf der starren Leiterplatte 1 befindlichen Leiterbahnen sind in Fig. 1 nicht dargestellt. Die einzelnen in ihrer jeweiligen Gesamtheit mit 4 bezeichneten Verbindungen sowie das Verfahren zu ihrer Herstellung werden im folgenden anhand von Fig. 2 näher beschrieben.

Im unteren Teil der Fig. 2 befindet sich auf der ausschnittsweise dargestellten starren Leiterplatte 1 eine Leiterbahn 5 an die sich elektrisch mit ihr verbunden eine Lötpfläche 6 anschliesst. Leiterbahn 5 und Lötfläche 6 bestehen aus Kupfer. Sie sind in üblicherweise, z.B. durch Ätzen hergestellt und können, wenn gewünscht, unterschiedliche Stärken haben. Zumindest die Lötfläche 6 ist verzinnt oder mit einer aus der SMD-Technik bekannten Lötpaste beschichtet.

Auf der oberen Fläche der starren Leiterplatte 1 befindet sich eine den Lotfluss behindernde Deckfolie 7. Die Deckfolie 7 ist so geformt, dass sie die Flötfläche 6 von oben freizugänglich lässt während sie die Leiterbahn 5 abdeckt. Anstelle der den Lotfluss verhindernden Deckfolie 7 kann auch eine entsprechend ausgebildete Beschichtung aus einem Lötstopplack verwendet werden. Die Oberfläche der Lötfläche 6 liegt geringfügig tiefer als die Oberfläche der den Lotfluss verhindernden Deckfolie 7.

Im oberen Teil der Fig. 2 befindet sich unter der als flexible Leiterplatte 2 dienenden Folie eine aus Kupfer bestehende Leiterbahn 3, die schmaler ausgebildet sein kann als in der Zeichnung dargestellt. Unterhalb der Leiterbahn 3 befindet sich, mit dieser verbunden, eine Lötfläche 8. Die Lötfläche 8 besitzt eine hohlzylindrische Gestalt und weist eine grössere Höhe bzw. Stärke auf als die Leiterbahn 3. Ihre zur Lötfläche 6 weisende untere Kreisringfläche ist verzinnt oder mit einer zinnhaltigen Lötpaste beschichtet. Der Aussendurchmesser der Kreisringfläche ist kleiner als die Seitenlänge der quadratischen Lötfläche 6 bzw. des in der Deckfolie 7 gebildeten Ausschnittes. Auf der Unterseite der Leiterbahn 3 befindet sich eine den Lotfluss verhindernde Deckfolie 9, die jedoch die zur Lötfläche 6 gerichtete kreisringförmige Lötfläche 8 nicht abdeckt. Anstelle der den Lotfluss verhindernden Deckfolie kann auch eine Schicht aus Lötstopplack verwendet werden.

Durch die flexible Leiterplatte 2 und die Leiterbahn 3 hindurch verläuft im Bereich der Lötfläche 8 und durch diese hindurch eine Kontrollbohrung 10. Die Unterseite der den Lotfluss verhindernden Deckfolie 9 ist mit einem wärmehärtbaren Kunststoff-Kleber beschichtet.

Zum Zusammenfügen der Verbindung werden die Leiterplatten 1 und 2 passgerecht aufeinander gedrückt und auf beiden Seiten, zumindest aber auf der Aussenseite der Leiterplatte 1 erwärmt. Das Erwärmen kann beispielsweise mit einer entsprechend grossen ebenen Fläche eines lötkolbenähnlichen Instrumentes erfolgen. Hierdruch schmilzt das auf den Lötflächen 6 und 8 befindliche Zinn und verbindet die Lötflächen miteinander. Zugleich härtet die Klebstoffschicht 11 aus und stellt eine zuverlässige mechanische Verbindung zwischen den Leiterplatten 1 und 2 her. Die Qualität der Lötverbindungen kann optisch durch die Kontrollbohrungen 10 hindurch kontrolliert werden.

## Patentansprüche

1. Verfahren zum Herstellen elektrisch leitender Verbindungen zwischen Anschlussflächen einer flexiblen Leiterplatte (2) und Anschlussflächen einer starren Leiterplatte (1), bei dem an den einander zugekehrten Anschlussflächen Lötflächen (6,8) ausgebildet, die Leiterplatten (1,2) mit ihren Lötflächen (6,8) zueinander ausgerichtet und unter Zwischenlage eines wärmehärtenden Klebers (11) durch Anwendung von Wärme und Druck miteinander verbunden werden,
**dadurch gekennzeichnet, dass**
die starre Leiterplatte (1) im Bereich ausserhalb der Lötflächen (6) mit einer den Lötfluss verhindernden Deckschicht (7) abgedeckt wird und die Lötflächen (6) dadurch in der Oberfläche der starren Leiterplatte (1) versenkt angeordnet werden, und
die flexible Leiterplatte (2) im Bereich ausserhalb der Lötflächen (8) mit einer den Lötfluss verhindernden Deckschicht (9) abgedeckt wird und die Lötflächen (8) aus der Oberfläche der Deckschicht (9) herausragend ausgebildet werden.

2. Verfahren nach Anspruch 1, **dadurch gekennzeichnet, dass** die Lötflächen (6) auf der starren Leiterplatte (1) rechteckig oder quadratisch ausgebildet werden.

3. Verfahren nach Anspruch 1 oder 2, **dadurch gekennzeichnet, dass** die Lötflächen (8) auf der flexiblen Leiterplatte (2) kreisförmig ausgebildet werden und der Durchmesser der kreisförmigen Lötfläche (9) kleiner ist als die Seitenlänge der quadratischen Lötfläche (6) auf der starren Leiterplatte (1).

4. Verfahren nach einem der Ansprüche 1 bis 3, **dadurch gekennzeichnet, dass** die Lötflächen (8) auf der flexiblen Leiterplatte (2) Kontrollbohrungen (10) enthalten, die im wesentlichen sekrecht zu den Lötflächen (8) verlaufen und sich durch die flexible Leiterplatte (2) hindurcherstrecken.

5. Verfahren nach einem der vorstehenden Ansprüche, **dadurch gekennzeichnet**, **dass** mindestens die flexible Leiterplatte (2) an der der starren Leiterplatte (1) zugekehrten Fläche mit dem wärmehärtenden Kleber (11) bedeckt wird, der ebenfalls von der Lötfläche (8) überragt wird.

## Claims

1. Method for establishing electrically conductive connections between terminal surfaces of a flexible printed cuitcuit board (2) and terminal surfaces of a rigid printed circuit board (1), with which soldering surfaces (6,8) are provided on the terminal surfaces facing each other and the printed circuit boards (1,2) are directed to each other with their soldering surfaces (6,8) and interconnected with an interlayer of heat curable adhesive (11) by using heat and pressure,
**characterized in that**
the rigid printed circuit board (1) is covered in the area outside the soldering surfaces (6) by a cover layer (7) preventing the solder flux and the soldering surfaces (6) thus are arranged in a recess in the surface of the rigid printed circuit board (1), and
the flexible printed circuit board (2) is covered in the area outside the soldering surfaces (8) by a cover layer (9) preventing the solder flux and the soldering surfaces (8) are arranged in a manner extending out of the surface of the cover layer (9).

2. Method as set forth in claim 1, **characterized in that** the soldering surfaces (6) on the rigid printed circuit board (1) are rectangular or square.

3. Method as set forth in claim 1 or 2, **characterized in that** the soldering surfaces (8) on the flexible printed circuit board (2) are circular and the diameter of the circular soldering surfaces (9) are smaller than the side length of the square soldering surfaces (6) on the rigid printed circuit board (1).

4. Method as set forth in anyone of the claims 1 to 3, **characterized in that** the soldering surfaces (8) on the flexible printed board (2) comprise check bores (10), which extend substantially perpendicular to the soldering surfaces (8) and through the flexible printed circuit board (2).

5. Method as set forth in anyone of the preceeding claims, **characterized in that** at least the flexible printed circuit board (2) is covered on the surface facing the rigid printed circuit board (1) by a heat curable adhesive (11), over which likewise the soldering surface (8) extends.

## Revendications

1. Méthode pour fabriquer des connexions électriquement conductives entre des surfaces de raccordement d'une carte imprimée (2) flexible et des surfaces de raccordement d'une carte imprimée (1) rigide, méthode dans laquelle des surfaces de brasage (6,8) sont formées sur les surfaces de raccordement l'une en face de l'autre, les cartes imprimées (1,2) sont alignées avec leurs surfaces de brasage (6,8) l'une vers l'autre, et elles sont reliées en interposant une colle thermodurcissable (11) par l'application de chaleur et de pression,
**caractérisée par le fait que**
la carte imprimée (1) rigide est couverte dans le domaine à l'extérieur des surfaces de brasage (6) par une couche de couverture (7) reprimant le flux de brasage et les surfaces de brasage (6) sont ainsi noyées dans la surface de la carte imprimée (1) rigide, et
la carte imprimée (2) rigide est couverte dans le domaine à l'extérieur des surfaces de brasage (8) par une couche de couverture (9) reprimant le flux de brasage, et les surfaces de brasage (8) sont formées de sorte à saillir de la surface de la couche de couverture (9).

2. Méthode selon la revendication 1, **caractérisée par le fait que** les surfaces de brasage (6) sur la carte imprimée (1) rigide sont rectangulaires ou carrées.

3. Méthode selon la revendication 1 ou 2, **caractérisée par le fait que** les surfaces de brasage (8) sur la carte imprimée (2) flexible sont circulaires, et le diamètre des surfaces de brasage (9) circulaires est inférieure à la longueur latérale de la surface de brasage (6) carrée sur la carte imprimée (1) rigide.

4. Méthode selon l'une des revendications 1 à 3, **caractérisée par le fait que** les surfaces de brasage (8) sur la carte imprimée (2) flexible comprennent des alésages de contrôle (10) généralement perpendiculaires aux surfaces de brasage (8) et s'étendant par la carte imprimée (2) flexible.

5. Méthode selon l'une des revendications ci-dessus, **caractérisée par le fait qu**'au moins la carte imprimée (2) flexible est couverte, sur la surface en face de la carte imprimée (1) rigide, par la colle thermodurcissable (11) également dépassée par la surface de brasage (8).
